# EUROPEAN PATENT APPLICATION

(11) **EP 4 270 505 A1**
(43) Date of publication of application: **01.11.2023**
(21) Application number: 21914921.8
(22) Date of filing: 26.03.2021
(51) Int. Cl.: H01L 41/047, H01L 41/09, H01L 41/113, H01L 41/187, H03H 9/17

(54) **FILM STRUCTURE AND ELECTRONIC DEVICE**

(30) Priority: 28.12.2020 US 202063131078 P
(71) Applicant: I-PEX Piezo Solutions Inc., Ube-shi, Yamaguchi 755-0152 (JP)
(72) Inventor: KONISHI, Akio, Ube-shi, Yamaguchi 755-0152 (JP); KANAMORI, Hiroaki, Ube-shi, Yamaguchi 755-0152 (JP); ANDO, Akira, Ube-shi, Yamaguchi 755-0152 (JP); HONDA, Yuuji, Ube-shi, Yamaguchi 755-0152 (JP)
(74) Representative: Gerauer, Marc Philippé
(86) International application number: PCT/JP2021/012854
(87) International publication number: WO 2022/145059

(57) **Abstract**

A membrane structure (10) includes: a substrate being a Si substrate or an SOI substrate; a buffer film containing ZrO₂ and formed on the substrate; and a piezoelectric film (11) formed on the buffer film, a polarization direction in the piezoelectric film (11) being preferentially oriented parallel to the substrate.

## Description

### Technical Field

The present invention relates to a membrane structure and an electronic device.

### Background Art

There are known: a membrane structure including a substrate and a piezoelectric film made as a membrane on the substrate; and an electronic device fabricated from the membrane structure.

JP 2003-198319 A (Patent Literature 1) discloses a technique in which a piezoelectric thin film is an aluminum nitride thin film exhibiting c-axis orientation in a thin film piezoelectric resonator provided with: a substrate made of a semiconductor or an insulator having an oscillation space; and a layered structure in which a bottom electrode, a piezoelectric thin film, and a top electrode are layered in this order at a position facing the oscillation space of the substrate.

### Citation List

### Patent Literature

Patent Literature 1: JP 2003-198319 A

### Non Patent Literature

Non Patent Literature 1: Yukihiro Kanechika, "Technology Trend of High Heat Dissipation AlN Substrate for Semiconductor Device", Journal of Japan Institute of Electronics Packaging, 2012, Vol. 15, No. 3, pp. 185-189

### Summary of Invention

### Technical Problem

In the technique described in Patent Literature 1 mentioned above, the aluminum nitride film as the piezoelectric film is c-axis oriented, and the polarization direction in the piezoelectric film is oriented perpendicular to the substrate. In this manner, it is easy to align the polarization direction in the piezoelectric film with a direction perpendicular to the substrate. On the other hand, there is a case where the polarization direction in the piezoelectric film is preferably aligned with a direction other than the direction perpendicular to the substrate in order to improve the permittivity characteristics and the withstand voltage characteristics, but the polarization direction in the piezoelectric film is difficult to align with a direction other than the direction perpendicular to the substrate. Depending on the device, there is a case where an advantageous device can be fabricated by aligning the polarization direction with a direction horizontal to the substrate.

The present invention has been made to solve the above-described problems of the prior art, and an object of the present invention is to provide a membrane structure having a piezoelectric film made as a membrane on a substrate, wherein a polarization direction in the piezoelectric film is aligned with a direction horizontal to the substrate.

### Solution to Problem

The outlines of representative inventions among the inventions disclosed in the present application will be briefly described as follows.

A membrane structure as one aspect of the present invention includes: a substrate that is a Si substrate or an SOI substrate; a buffer film containing ZrO₂ and formed on the substrate; and a piezoelectric film formed on the buffer film, a polarization direction in the piezoelectric film being preferentially oriented parallel to the substrate.

As another aspect, the membrane structure may be further provided with a metal film on the buffer film. As another aspect, the metal film may be a Pt film, a Mo film, a W film, a Ru film, or a Cu film. Furthermore, the membrane structure may be further provided with an SRO film on the metal film.

As another aspect, the piezoelectric film may be made of a nitride. As another aspect, the nitride may be AlN. As another aspect, the nitride may be doped with Sc.

An electronic device as one aspect of the present invention is an electronic device fabricated from the membrane structure.

An electronic device as an aspect of the present invention is an electronic device fabricated from the membrane structure, wherein a comb electrode is provided on a top surface or a bottom surface of a piezoelectric film in the membrane structure.

As another aspect, the polarization direction in the piezoelectric film may be the direction of the comb teeth of the comb electrode. Furthermore, as another aspect, the electronic device may include a matching layer on the substrate.

As another aspect, a hollow part may be provided below the piezoelectric film.

Furthermore, as another aspect, the electronic device may be provided with a top electrode and a bottom electrode on the top and bottom of the piezoelectric film, respectively. As another aspect, the area of the overlapping portion between the top electrode and the bottom electrode may be smaller than the area of the hollow part. As another aspect, the area of the overlapping portion between the top electrode and the bottom electrode may be 1/2 or less of the area of the hollow part. Furthermore, as another aspect, the electronic device may include a matching layer on the substrate.

As another aspect, the matching layer may be of a material whose hardness increases as the temperature rises. As another aspect, the material may be a Si compound.

As another aspect, either the top or bottom of the piezoelectric film may be fixed.

As another aspect, the piezoelectric film may be made of a nitride. As another aspect, the nitride may be AlN.

### Advantageous Effects of Invention

By applying one aspect of the present invention, there can be realized a membrane structure including a piezoelectric film made as a membrane on a substrate, wherein a polarization direction in the piezoelectric film is aligned with a direction horizontal to the substrate.

### Brief Description of Drawings

Fig. 1 is a cross-sectional view of a membrane structure of a first embodiment.
Fig. 2 is a cross-sectional view of the membrane structure of the first embodiment.
Fig. 3 is a cross-sectional view of the membrane structure of the first embodiment.
Fig. 4 is a cross-sectional view of the membrane structure of the first embodiment.
Fig. 5 is a cross-sectional view of an electronic device of a second embodiment.
Fig. 6 is a cross-sectional view of the electronic device of the second embodiment.
Fig. 7 is a cross-sectional view of the electronic device of the second embodiment.
Fig. 8 is a cross-sectional view of the electronic device of the second embodiment.
Fig. 9 is a cross-sectional view of the electronic device of the second embodiment.
Fig. 10 is a cross-sectional view of the electronic device of the second embodiment.
Fig. 11 is a cross-sectional view of the electronic device of the second embodiment.
Fig. 12 is a cross-sectional view of the electronic device of the second embodiment.
Fig. 13 is a perspective view of an electronic device of a third embodiment.
Fig. 14 is a perspective view of the electronic device of the third embodiment.
Fig. 15 is a perspective view of the electronic device of the third embodiment.
Fig. 16 is a graph showing an example of Θ-2Θ spectrum by XRD method for the membrane structure of Example 1 formed up to SRO layer.
Fig. 17 is a diagram illustrating the crystal structure of a-axis-oriented AlN.
Fig. 18 is a diagram illustrating the crystal structure of c-axis oriented AlN.
Fig. 19 is a graph showing the result of the out-of-plane measurement for the membrane structure of Example 1.
Fig. 20 is a graph showing the result of the out-of-plane measurement for the membrane structure of Example 2.
Fig. 21 is a graph showing the result of the reciprocal-space map measurement for the membrane structure of Example 1.
Fig. 22 is a graph showing an example of Θ-2Θ spectrum by XRD method for the membrane structure of Example 3.
Fig. 23 is a plan view of a sample having a cantilever shape of the membrane structure of Example 3.
Fig. 24 is a cross-sectional view of the sample having a cantilever shape of the membrane structure of Example 3.
Fig. 25 is a plan view of a sample having a pad shape of the membrane structure of Example 3.
Fig. 26 is a cross-sectional view of the sample having a pad shape of the membrane structure of Example 3.

### Description of Embodiments

Hereinafter, the embodiments of the present invention will be described with reference to the drawings.

Note that the disclosure is merely an example, and appropriate changes therefrom that can be easily conceived by those skilled in the art in keeping the gist of the invention are naturally included in the scope of the present invention. Moreover, in order to make the description clearer, the width, thickness, shape, and the like of each part may be shown schematically in the drawings than the embodiment, but they are merely examples and do not limit the interpretation of the present invention.

In the present specification and each drawing, elements similar to those described above in relation to the previously presented drawings are denoted by the same reference numerals, and detailed description thereof may be appropriately omitted.

Furthermore, in the drawings used in the embodiments, hatching (shading) added to distinguish a structure may be omitted in accordance with the drawings.

Note that, in the following embodiments, in a case where a range is indicated as "A to B", this wording indicates that the range is "A or more and B or less", unless otherwise specified.

### (First Embodiment)

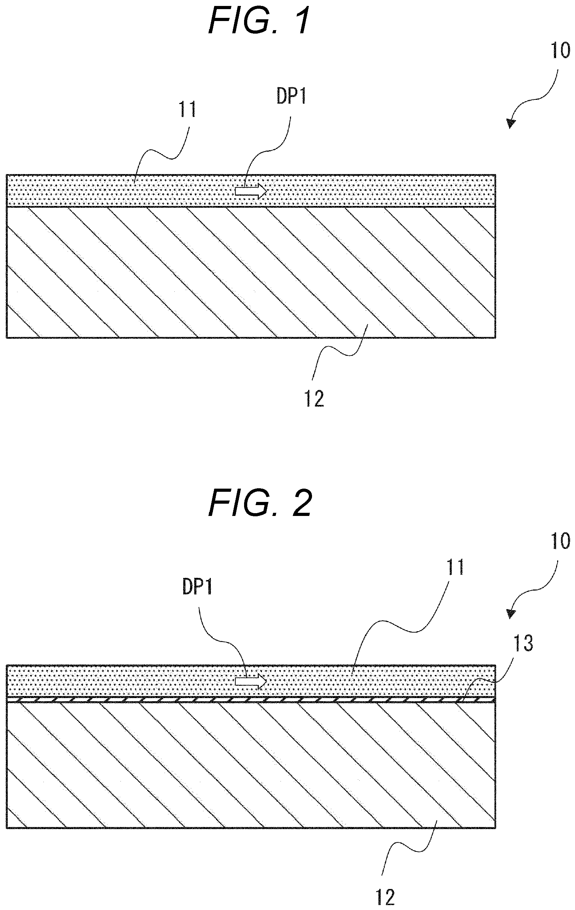

First, there will be described a membrane structure of a first embodiment as an embodiment of the present invention. Figs. 1 to 4 each are a cross-sectional view of a membrane structure of the first embodiment.

As illustrated in Fig. 1, the membrane structure 10 of the first embodiment is a membrane structure including a piezoelectric film 11 and a substrate 12, and is characterized in that a polarization direction in the piezoelectric film 11, namely, in a piezoelectric membrane portion is preferentially oriented parallel to the substrate 12. In Fig. 1, the polarization direction is indicated by a polarization direction DP1 (the same applies to Fig. 2 and Figs. 5 to 15). Since the polarization direction in the piezoelectric film 11 is preferentially oriented parallel to the substrate 12, there can be realized a membrane structure where the polarization direction in the piezoelectric film is aligned with a direction horizontal to the substrate.

Alternatively, as illustrated in Fig. 2, the membrane structure 10 of the first embodiment is a membrane structure including a piezoelectric film 11, an electrode 13, and a substrate 12, and is characterized in that a polarization direction in the piezoelectric film 11, namely, in a piezoelectric membrane portion is preferentially oriented parallel to the substrate 12. As described above, since the polarization direction in the piezoelectric film 11 is preferentially oriented parallel to the substrate 12, there can be realized a membrane structure where the polarization direction in the piezoelectric film is aligned with a direction horizontal to the substrate.

Note that, in the present specification, the wording of "the polarization direction in the piezoelectric film 11 is preferentially oriented parallel to the substrate 12" means the fact that, a portion, out of the piezoelectric film 11, where the polarization direction is oriented so as to be parallel to the substrate 12 is more than 50% of the entire piezoelectric film 11 in volume fraction, for example; and means the fact that when a Θ-2Θ spectrum by an X-ray diffraction (XRD) method is measured, for example, the peak intensity of the maximum peak indicating the portion where the polarization direction is oriented so as to be parallel to the substrate 12 is higher than the peak intensity of the maximum peak indicating the portion where the polarization direction is not oriented so as to be parallel to the substrate 12 in the measured Θ-2Θ spectrum. In addition, the case where the polarization direction is parallel to the substrate 12 includes not only the case where the polarization direction is completely parallel to the top surface of the substrate 12 but also a case where the polarization direction and the direction of the polarization direction projected onto the top surface of the substrate 12 form an angle of 20° or less.

Preferably, the material of the piezoelectric film 11 is a nitride. In other words, the piezoelectric film 11 is made of a nitride. In a case where the material of the piezoelectric film 11 is a nitride, there can be used aluminum nitride (AlN), gallium nitride (GaN), or the like, which is a lead-free material and is a piezoelectric material excellent in piezoelectric characteristics.

The material of the piezoelectric film 11 is preferably an a-axis oriented AlN-based piezoelectric material, namely, a piezoelectric material containing AlN as a main component. That is, the nitride is AlN. In a case where the material of the piezoelectric film 11 contains AlN as a main component, there can be used a piezoelectric material being a lead-free material, containing an element abundant on earth with a high Clarke number, and being excellent in piezoelectric characteristics. Furthermore, since AlN is a-axis oriented, AlN can be oriented such that the c-axis direction as the polarization direction of AlN is parallel to the substrate 12. Note that AlN has a hexagonal wurtzite structure, and is polarized in c-axis direction. GaN also has a wurtzite structure.

Note that, in the present specification, the wording of "the piezoelectric material containing AlN as a main component" means the fact that the AlN content in the piezoelectric material is more than 50% by weight, or the AlN content in the piezoelectric material is more than 50% by mole.

Preferably, scandium (Sc) is doped, namely, added into the nitride. In a case where AlN or GaN, for example, is used as the nitride material, Sc is added to the nitride, so that the piezoelectric characteristics can be improved.

Preferably, the polarizability of the piezoelectric film 11 is 80% or more. As a result of this, there can be realized a membrane structure where the polarization direction in the piezoelectric film is aligned with a direction horizontal to the substrate.

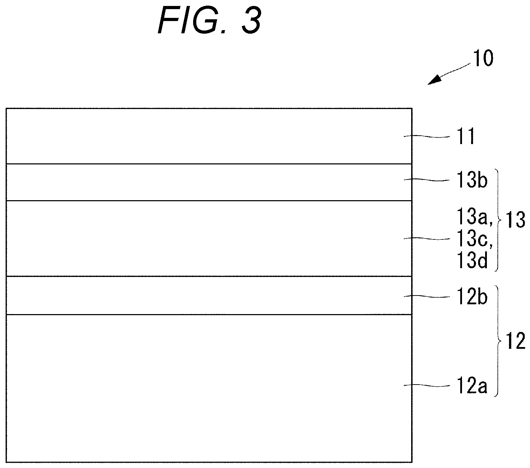

Preferably, as illustrated in Fig. 3, the substrate 12 has a structure in which a Si layer and a ZrO₂ layer are layered in this order. Si represents silicon and ZrO₂ represents zirconium oxide. ZrO₂ serves as a buffer film, and contributes to allowing a piezoelectric material formed thereon to be formed with an excellent crystallinity. Preferably, the substrate 12 includes a (100)-oriented Si layer 12a and a ZrO₂ layer 12b formed on the Si layer 12a. The ZrO₂ layer 12b preferably includes (200)-oriented ZrO₂ and (002)-oriented ZrO₂. As the Si layer 12a of the substrate 12, a (100)-oriented Si substrate can be used. In such a case, the piezoelectric film 11 where the polarization direction in the piezoelectric film 11 is oriented parallel to the substrate 12, such as a piezoelectric material containing a-axis oriented AlN-based piezoelectric material as a main component, can be easily formed on the substrate 12. Furthermore, the (100)-oriented Si substrate can be used as the Si layer 12a of the substrate 12, so that an electronic device where the polarization direction in the piezoelectric film 11 is aligned with a direction horizontal to the substrate can be formed on a low-priced semiconductor substrate.

As illustrated in Fig. 3, an electrode 13 has a structure in which a Pt (200) layer and a SrRuO₃ (100) layer are layered in this order. Pt represents platinum and SrRuO₃(SRO) represents strontium ruthenate. In other words, the electrode 13 preferably includes: a Pt layer 13a that is formed on a substrate 12 and is (200)-oriented; and an SRO layer 13b that is formed on the Pt layer 13a and is (100)-oriented. In such a case, the piezoelectric film 11 where the polarization direction in the piezoelectric film 11 is oriented parallel to the substrate 12, such as a piezoelectric material containing a-axis oriented AlN-based piezoelectric material as a main component, can be easily formed on the substrate 12 with the electrode 13 as a bottom electrode interposed therebetween.

Note that Si layer 12a is not limited to the case of being (100)-oriented; the ZrO₂ layer 12b is not limited to the case of being (200)-oriented or (002)-oriented; Pt layer 13a is not limited to the case of being (200)-oriented; and the electrode 13 is not limited to the case of including the SRO layer 13b that is formed on the Pt layer 13a and is (100)-oriented. Furthermore, the Si layer 12a of the substrate 12 can be considered as a substrate. In such a case, the membrane structure 10 of the first embodiment is a membrane structure including a substrate (Si layer 12a) as a Si substrate, a buffer film (ZrO₂ layer 12b) containing ZrO₂ and formed on the substrate (Si layer 12a), and a piezoelectric film 11 formed on the buffer film (ZrO₂ layer 12b) with a metal film (Pt layer 13a) interposed therebetween, wherein a polarization direction in the piezoelectric film 11 is preferentially oriented parallel to the top surface of the substrate 12. The piezoelectric film 11 is a piezoelectric film made as a membrane on Pt/ZrO₂/Si. Note that in a case where the electrode 13 includes the Pt layer 13a and the SRO layer 13b, that is, in a case where the membrane structure 10 is further provided with the metal film (Pt layer 13a) on the buffer film (ZrO₂ layer 12b) and is further provided with the SRO film (SRO layer 13b) on the metal film (Pt layer 13a), the piezoelectric film 11 is a piezoelectric film made as a membrane on the substrate (Si layer 12a) as a Si substrate, with the ZrO₂ film (ZrO₂ layer 12b), the Pt film (Pt layer 13a), and the SRO film (SRO layer 13b) interposed therebetween in order from the bottom.

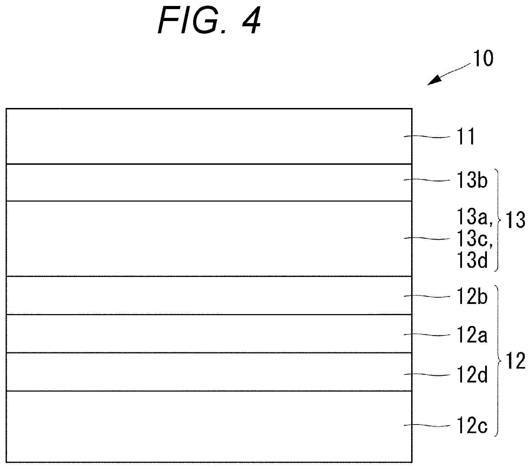

As illustrated in Fig. 4, in place of the Si substrate, a silicon on insulator (SOI) substrate that is a semiconductor substrate can be used as the Si layer 12a of the substrate 12. In the case where an SOI substrate is used as the substrate 12, the substrate 12 includes: a substratum 12c made of Si; a buried oxide (BOX) layer 12d which is a buried oxide film formed on the substratum 12c; and a Si layer 12a which is a silicon on insulator (SOI) layer formed on the BOX layer 12d. As a result of this, a membrane structure where the permittivity characteristics and withstand voltage characteristics of the piezoelectric film are excellent can be formed on the SOI substrate, and an electronic device including a micro electro mechanical system (MEMS) having a plurality of piezoelectric elements formed with high shape accuracy can be easily formed on the SOI substrate.

Note that the Si layer 12a of the substrate 12 can be considered as a substrate. In such a case, the membrane structure 10 of the first embodiment is a membrane structure including a substrate (Si layer 12a) as an SOI substrate, a buffer film (ZrO₂ layer 12b) containing ZrO₂ and formed on the substrate (Si layer 12a), and a piezoelectric film 11 formed on the buffer film (ZrO₂ layer 12b) with a metal film (Pt layer 13a) interposed therebetween, wherein a polarization direction in the piezoelectric film 11 is preferentially oriented parallel to the top surface of the substrate 12. The piezoelectric film 11 is a piezoelectric film made as a membrane on Pt/ZrO₂/Si on SOI. Note that in a case where an electrode 13 includes a Pt layer 13a and an SRO layer 13b, that is, in a case where the membrane structure 10 is further provided with a metal film (Pt layer 13a) on the buffer film (ZrO₂ layer 12b) and is further provided with an SRO film (SRO layer 13b) on the metal film (Pt layer 13a), the piezoelectric film 11 is a piezoelectric film made as a membrane on the substrate (Si layer 12a) that is an SOI substrate, with the ZrO₂ film (ZrO₂ layer 12b), the Pt film (Pt layer 13a), and the SRO film (SRO layer 13b) interposed therebetween in order from the bottom.

The electrode 13 may include a Mo layer 13c or a W layer 13d in place of the Pt layer 13a. In such a case, the electrode 13 includes an SRO layer 13b formed on the Mo layer 13c or the W layer 13d. Also, in such a case, the membrane structure 10 of the first embodiment includes the piezoelectric film 11 made as a membrane on the substrate (Si layer 12a) that is a Si substrate or an SOI substrate with the ZrO₂ film (ZrO₂ layer 12b) and the Mo film (Mo layer 13c) or the W film (W layer 13d) interposed therebetween in order from the bottom. Also in such a case, as in the case where the electrode 13 includes the Pt layer 13a, the piezoelectric film 11 where the polarization direction in the piezoelectric film 11 is oriented parallel to the substrate 12, such as a piezoelectric material containing a-axis oriented AlN-based piezoelectric material as a main component, can be easily formed on the substrate 12 with the electrode 13 as a bottom electrode interposed therebetween. Note that, a Ru layer or a Cu layer may be used besides the materials described above as the material for the electrode 13a, 13c, or 13d. These materials are typically used as electrode materials.

The film thickness of the piezoelectric film 11 is preferably 100 nm or more. In a case where the film thickness of the piezoelectric film 11 is 100 nm or more, the film thickness of the piezoelectric film 11 can be sufficiently increased as compared with a case where the film thickness of the piezoelectric film 11 is less than 100 nm, and hence an electronic device where the polarization direction in the piezoelectric film is aligned with the direction horizontal to the substrate can be formed on the substrate.

### (Second Embodiment)

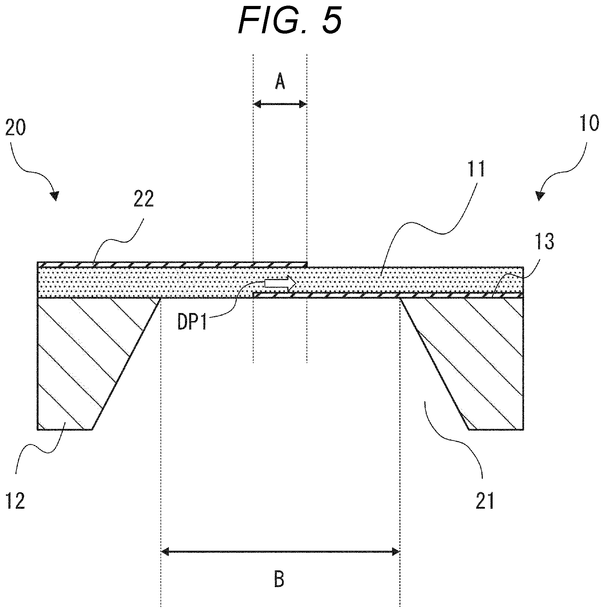

Next, an electronic device according to a second embodiment which is an embodiment of the present invention will be described. The electronic device of the second embodiment is a bulk acoustic wave (BAW) filter or a film bulk acoustic resonator (FBAR) provided with the membrane structure of the first embodiment. Figs. 5 to 12 each are a cross-sectional view of an electronic device of the second embodiment.

As illustrated in Fig. 5, the electronic device 20 of the second embodiment is an electronic device provided with a membrane structure 10 including: a piezoelectric film 11; two electrodes; and a substrate 12, and is characterized in that a polarization direction in the piezoelectric film 11 is preferentially oriented parallel to the substrate 12.

Also with regard to the membrane structure 10 provided in the electronic device 20 of the second embodiment, there can be included a piezoelectric film 11, an electrode 13, and a substrate 12, as with the case of the membrane structure 10 of the first embodiment. That is, the electronic device 20 of the second embodiment includes the electrode 13 and the piezoelectric film 11 on the substrate 12. Hence, there may be omitted the description regarding portions similar to the piezoelectric film 11, the electrode 13, and the substrate 12 included in the membrane structure 10 of the first embodiment, among the piezoelectric film 11, the electrode 13, and the substrate 12 included in the membrane structure 10.

On the other hand, the electronic device 20 of the second embodiment is a BAW filter or a FBAR provided with the membrane structure 10 of the first embodiment, thus, in the substrate 12, a hollow portion, that is, a hollow part 21 is provided below the piezoelectric film 11. In such a case, at least a central portion out of the portion of the piezoelectric film 11 located above the hollow part 21 is not constraint by the substrate 12 and can oscillate freely, so that a bulk acoustic wave can be easily generated in the central portion.

Furthermore, in the membrane structure 10 provided in the electronic device 20 of the second embodiment, there is provided an electrode 22 as an upper electrode or a top electrode formed on the piezoelectric film 11. In such a case, the electrode 13 is an electrode as a lower electrode or a bottom electrode formed under the piezoelectric film 11. That is, the electrode 22 and the electrode 13 are a top electrode and a bottom electrode formed on the top and the bottom of the piezoelectric film 11, respectively. In the example illustrated in Fig. 5, the electrodes are formed above and below in contact with the piezoelectric film 11. Furthermore, the membrane structure 10 is a membrane structure including a piezoelectric film 11, an electrode 13 and an electrode 22 as two electrodes, and a substrate 12, and is characterized in that a polarization direction in the piezoelectric film 11, namely, in a piezoelectric membrane portion is preferentially oriented parallel to the substrate 12. In such a case, a voltage such as an alternating voltage is applied between the electrode 13 and the electrode 22, whereby an electric field such as an alternating electric field in the thickness direction of the piezoelectric film 11 can be easily applied to the piezoelectric film 11, so that a bulk acoustic wave can be easily generated in the piezoelectric film 11. In addition, there can be generated or allowed to pass a bulk acoustic wave having a resonance frequency determined in accordance with elastic characteristics or the like of the piezoelectric film 11, and hence the electronic device is enabled to serve as a resonator or a filter.

Note that also in the second embodiment, as in the first embodiment, a substrate including a (100)-oriented Si layer 12a (see Fig. 3) and a ZrO₂ layer 12b (see Fig. 3) formed on the Si layer 12a can be used as the substrate 12. The ZrO₂ layer 12b preferably includes (200)-oriented ZrO₂ and (002)-oriented ZrO₂. In such a case, the Si layer 12a of the substrate 12 can be considered as a substrate, and the electronic device 20 of the second embodiment is an electronic device including the electrode 13 and the piezoelectric film 11 on the substrate (Si layer 12a) which is a Si substrate, wherein the polarization direction in the piezoelectric film 11 is preferentially oriented parallel to the substrate 12, and the hollow part 21 is provided below the piezoelectric film 11.

Preferably, the area A of the overlapping portion between the top and bottom electrodes is smaller than the area B of the piezoelectric film 11 and the lower electrode both uncovered in the hollow portion. That is, the area of the overlapping portion between the electrode 22 as a top electrode and the electrode 13 as a bottom electrode is smaller than the area of the hollow part 21. In such a case, a voltage is applied between the electrode 22 and the electrode 13, whereby a portion to which an electric field in the thickness direction is applied out of the piezoelectric film 11 can be reliably spaced apart from the substrate 12. For this reason, the portion to which an electric field in the thickness direction is applied out of the piezoelectric film 11 is not constrained by the substrate 12 and can freely oscillate, so that a bulk acoustic wave can be more easily generated.

Preferably, the area ratio of the area A of the overlapping portion between the top and bottom electrodes to the area B of the piezoelectric film 11 and the lower electrode both uncovered in the hollow portion, that is, A/B is less than 1/2, or not greater than 1/2. That is, the area of the overlapping portion between the electrode 22 as a top electrode and the electrode 13 as a bottom electrode is 1/2 or less of the area of the hollow part 21. In such a case, a voltage is applied between the electrode 22 and the electrode 13, whereby the portion of the piezoelectric film 11 to which an electric field in the thickness direction is applied can be more reliably spaced apart from the substrate 12. For this reason, the portion of the piezoelectric film 11 to which an electric field in the thickness direction is applied is less constrained by the substrate 12, and can oscillate more freely, so that a bulk acoustic wave can be generated more easily.

Note that, as described above, also with regard to the membrane structure 10 provided in the electronic device 20 of the second embodiment, there can be included the piezoelectric film 11, the electrode 13, and the substrate 12, as with the case of the membrane structure 10 of the first embodiment. Therefore, also with regard to the membrane structure 10 provided in the electronic device 20 of the second embodiment, as with the case of the membrane structure 10 of the first embodiment, instead of the Si substrate, an SOI substrate as a semiconductor substrate can be used for the Si layer 12a (see Fig. 4) of the substrate 12, and the electrode 13 can include a Mo layer 13c (see Fig. 3) or a W layer 13d (see Fig. 3) instead of the Pt layer 13a (see Fig. 3). Note that, a Ru layer or a Cu layer may be used besides the materials described above as the material for the electrode 13a, 13c, or 13d. These materials are typically used as electrode materials. Also with regard to the membrane structure 10 provided in the electronic device 20 of the second embodiment, as with the case of the membrane structure 10 of the first embodiment, the material of the piezoelectric film 11 is preferably a nitride, the material of the piezoelectric film 11 is preferably a-axis oriented AlN-based piezoelectric material, that is, the nitride is preferably AlN, the nitride is preferably doped with Sc, the polarizability of the piezoelectric film 11 is preferably 80% or more, and the film thickness of the piezoelectric film is preferably 100 nm or more.

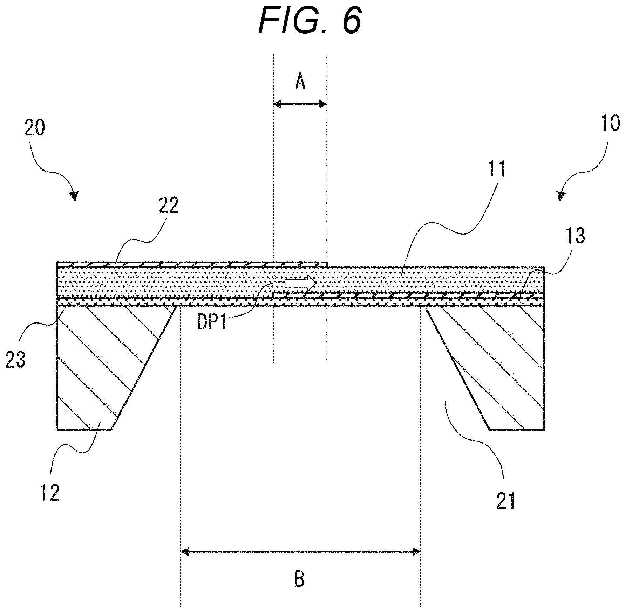

As illustrated in Fig. 6, it is preferable to provide a dielectric layer 23 as a dielectric layer or a matching layer between the substrate 12 and the piezoelectric film 11. That is, the electronic device 20 illustrated in Fig. 6 includes a dielectric layer 23 as a matching layer on the substrate 12 and under the bottom electrode, that is, under the electrode 13, in addition to the portions included in the electronic device 20 illustrated in Fig. 5. For example, in a case where a portion other than the dielectric layer 23 out of the electronic device 20 is made of a material having a property of softening up with an increase in temperature and the dielectric layer 23 is made of a material having a property of stiffening up with an increase in temperature, the temperature dependence of the permittivity characteristics or of the piezoelectric characteristics, that is, the temperature characteristics of the electronic device 20 can be stabilized or adjusted.

Preferably, the dielectric layer 23 is a Si compound, for example, silicon dioxide (SiO₂). In such a case, the dielectric layer 23 is a dielectric layer made of a material having high compatibility with the manufacturing process of the semiconductor device, and hence the dielectric layer 23 can be easily formed.

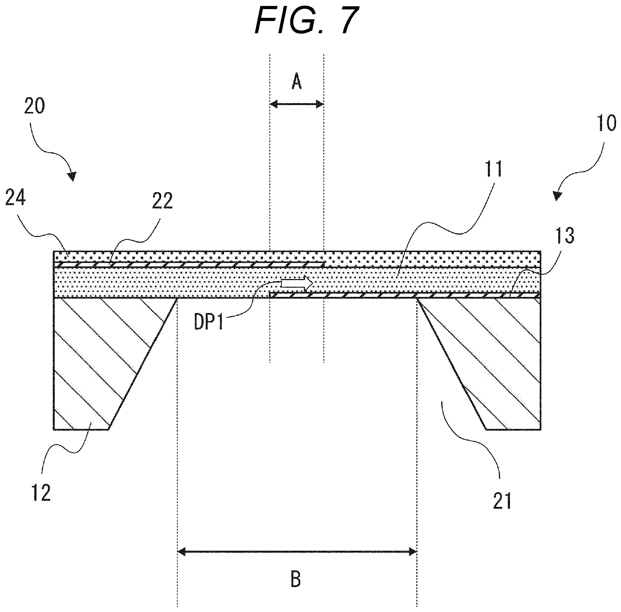

As illustrated in Fig. 7, a dielectric layer 24 as an upper dielectric layer is preferably provided on the piezoelectric film 11. That is, the electronic device 20 illustrated in Fig. 7 includes the dielectric layer 24 as an upper dielectric layer on the piezoelectric film 11, in addition to the portions included in the electronic device 20 illustrated in Fig. 5. For example, in a case where a portion other than the dielectric layer 24 out of the electronic device 20 is made of a material having a property of softening up with an increase in temperature and the dielectric layer 24 is made of a material having a property of stiffening up with an increase in temperature, the temperature dependence of the permittivity characteristics or of the piezoelectric characteristics, that is, the temperature characteristics of the electronic device 20 can be stabilized or adjusted.

Preferably, the dielectric layer 24 is a Si compound, for example, SiO₂. In such a case, the dielectric layer 24 is a dielectric layer made of a material having high compatibility with the manufacturing process of the semiconductor device, and hence the dielectric layer 24 can be easily formed.

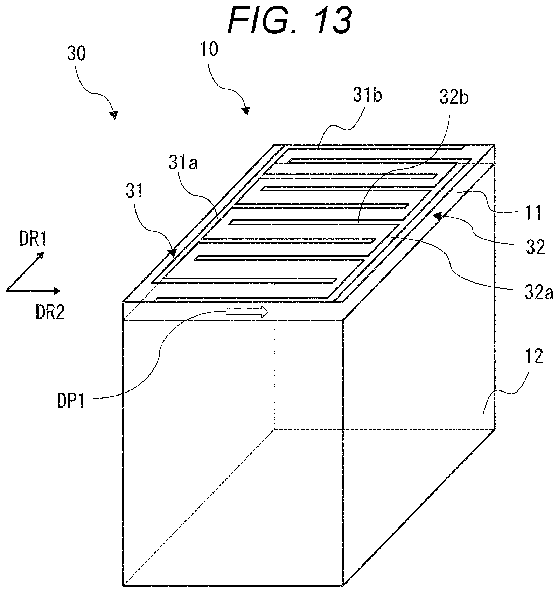

Note that, in the examples illustrated in Figs. 5 to 7, for example, in the example illustrated in Fig. 5, either the top or bottom of the piezoelectric film 11 can be made so as not to be fixed (the same applies to the third embodiment to be described later with reference to Figs. 13 to 15). As a result, there can be realized an electronic device taking advantage of a displacement in the sliding direction.

Furthermore, in the examples illustrated in Figs. 5 to 7, for example, in the examples illustrated in Figs. 6 and 7, one side of the piezoelectric films 11 is fixed, and the other side thereof is enabled to be fixed more weakly than the one side by using a material whose hardness varies with the temperature. That is, one of the top and bottom of the piezoelectric film 11 is fixed, and the other of the top and bottom of the piezoelectric film 11 is enabled to be fixed weakly with a material whose hardness varies with the temperature (the same applies to the third embodiment to be described later with reference to Figs. 13 to 15). As a result, there can be realized an electronic device that takes advantage of displacement in sliding direction and that is capable of compensating for temperature characteristics.

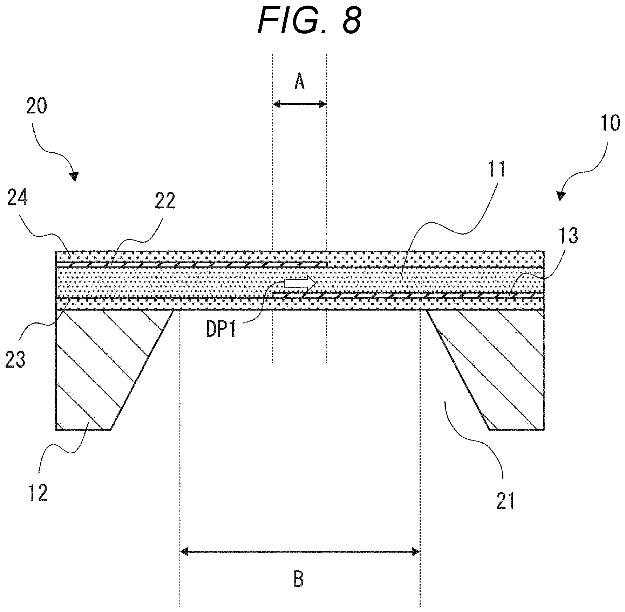

As illustrated in Fig. 8, it is preferable that a dielectric layer 23 as a lower dielectric layer is provided between the substrate 12 and the piezoelectric film 11 and that a dielectric layer 24 as an upper dielectric layer is provided on the piezoelectric film 11. That is, the electronic device 20 illustrated in Fig. 8 includes: the dielectric layer 23 as a matching layer on the substrate 12 and under a bottom electrode, that is, under the electrode 13; and the dielectric layer 24 as an upper dielectric layer on the piezoelectric film 11, in addition to the portions included in the electronic device 20 illustrated in Fig. 5. Furthermore, in the example illustrated in Fig. 8, the dielectric layer 24 is provided on a top electrode, that is, on the electrode 22. That is, also in the example illustrated in Fig. 8, the electrodes are formed above and below in contact with the piezoelectric film 11. For example, in a case where a portion other than the dielectric layer 23 and the dielectric layer 24 out of the electronic device 20 is made of a material having a property of softening up with an increase in temperature, and the dielectric layer 23 and the dielectric layer 24 each are made of a material having a property of stiffening up with an increase in temperature, the temperature dependence of the permittivity characteristics or of the piezoelectric characteristics, that is, the temperature characteristics of the electronic device 20 can be stabilized or adjusted. As described above, the dielectric layer 23 and the dielectric layer 24 each are a Si compound, for example, SiO₂.

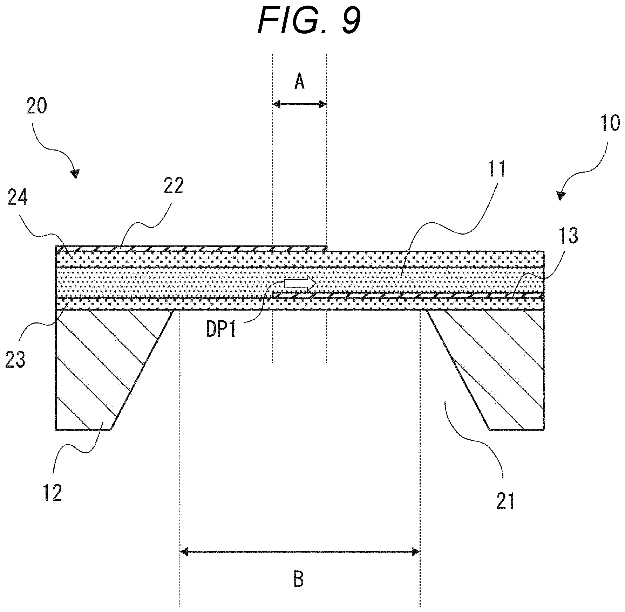

As illustrated in Fig. 9, it is preferable that the dielectric layer 23 as a lower dielectric layer is provided between the substrate 12 and the piezoelectric film 11 as well as the dielectric layer 24 as an upper dielectric layer is provided on the piezoelectric film 11, and that the electrode 22 as an upper electrode is provided on the dielectric layer 24 as an upper dielectric layer. That is, the electronic device 20 illustrated in Fig. 9 is configured such that the stacking order of the electrode 22 and the dielectric layer 24 in the vertical direction is reversed in the electronic device 20 illustrated in Fig. 8. In addition, the structure illustrated in Fig. 9 is not a structure in which electrodes are formed above and below in contact with the piezoelectric film 11. Even in such a case, an effect similar to that of the electronic device 20 illustrated in Fig. 8 can be obtained. In addition, as described above, the dielectric layer 23 and the dielectric layer 24 each are a Si compound, for example, SiO₂.

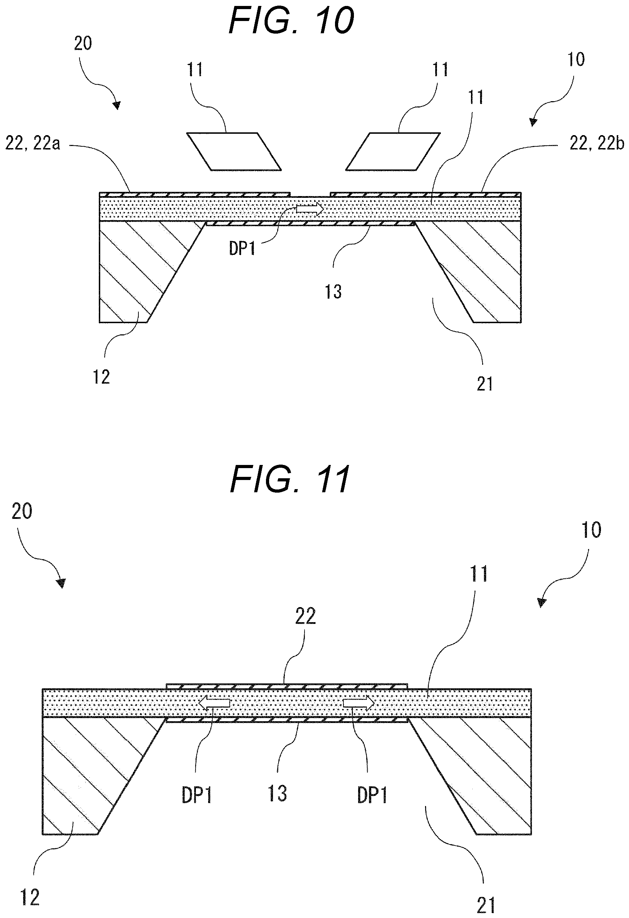

As illustrated in Fig. 10, either the electrode 13 or the electrode 22 preferably includes multiple electrodes on bottom or top thereby having two or more kinds of electric field directions in the plane. In the example shown in Fig. 10, the electronic device 20 includes two electrodes 22 as top electrodes. In Fig. 10, the two electrodes 22 are illustrated as an electrode 22a and an electrode 22b. As a result of this, there can be more easily realized an electronic device taking advantage of a displacement in the sliding direction. Note that, Fig. 10 schematically illustrates a case where the piezoelectric film 11 has displacements in two kinds of sliding directions.

As illustrated in Fig. 11, it is preferable that the polarization direction (polarization direction DP1) in the piezoelectric film 11 is parallel to the substrate 12 and preferentially oriented in a plurality of directions, and that the electrode 22 and the electrode 13 are provided on the top and the bottom of the piezoelectric body, respectively. Even in such a case, there can be more easily realized an electronic device taking advantage of a displacement in the sliding direction.

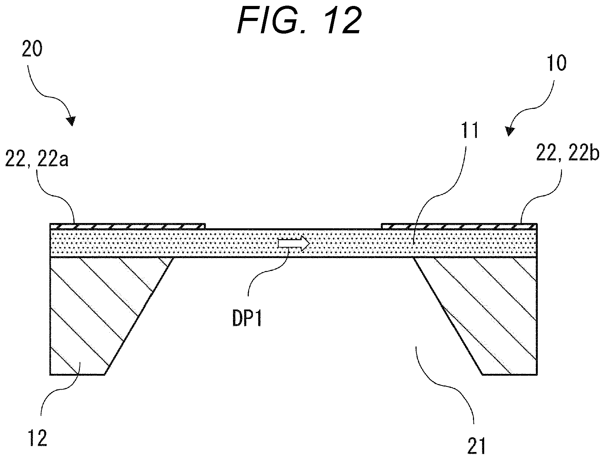

As illustrated in Fig. 12, it is preferable that there is a plurality of electrodes on the top of or the bottom of the piezoelectric film 11. In the example illustrated in Fig. 12, no bottom electrode is provided, and as top electrodes two electrodes 22, that is, an electrode 22a and an electrode 22b are provided. Even in such a case, there can be more easily realized an electronic device taking advantage of a displacement in the sliding direction.

### (Third Embodiment)

Next, an electronic device of a third embodiment which is an embodiment of the present invention will be described. The electronic device of the third embodiment is a surface acoustic wave (SAW) filter provided with the membrane structure of the first embodiment. Figs. 13 to 15 each are a perspective view of an electronic device of the third embodiment.

As illustrated in Fig. 13, the electronic device 30 of the third embodiment is an electronic device provided with a membrane structure 10 including a piezoelectric film 11, an interdigitated electrode, and a substrate 12, and is characterized in that a polarization direction in the piezoelectric film 11 is preferentially oriented parallel to the substrate 12.

Also with regard to the membrane structure 10 provided in the electronic device 30 of the third embodiment, there can be included the piezoelectric film 11 and the substrate 12, as with the case of the membrane structure 10 of the first embodiment. Therefore, there may be omitted the description regarding portions similar to the piezoelectric film 11 and the substrate 12 included in the membrane structure 10 of the first embodiment, among the piezoelectric film 11 and the substrate 12 included in the membrane structure 10.

On the other hand, the electronic device 30 of the third embodiment is an SAW filter provided with the membrane structure 10 of the first embodiment, and thus an electrode 31 and an electrode 32 as an interdigitated electrode (a comb electrode) are formed on the top surface or the bottom surface of the piezoelectric film 11, namely, of the piezoelectric material portion. That is, the electronic device 30 of the third embodiment includes the electrode 31 and the electrode 32 as well as the piezoelectric film 11, on the substrate 12. In such a case, an alternating voltage is applied between the electrode 31 and the electrode 32, whereby a surface acoustic wave can be easily generated on the piezoelectric film 11. In addition, there can be generated or allowed to pass a surface acoustic wave having a resonance frequency determined in accordance with the elastic characteristics and the like of the substrate 12, the piezoelectric film 11, as well as the electrode 31 and the electrode 32, and hence the electronic device is enabled to serve as a resonator or a filter.

Note that, also in the third embodiment, as in the first embodiment, as the substrate 12, there can be used a substrate including a (100)-oriented Si layer 12a (see Fig. 3) and a ZrO₂ layer 12b (see Fig. 3) formed on the Si layer 12a. The ZrO₂ layer 12b preferably includes (200)-oriented ZrO₂ and (002)-oriented ZrO₂. In such a case, the Si layer 12a of the substrate 12 can be considered as a substrate, and the electronic device 30 of the third embodiment is an electronic device including the piezoelectric film 11 on the substrate (Si layer 12a) as a Si substrate, wherein the polarization direction in the piezoelectric film 11 is preferentially oriented parallel to the substrate 12.

In the example illustrated in Fig. 13, an electrode 31 and an electrode 32 as an interdigitated electrode are formed on the top surface of the piezoelectric film 11. That is, in the example illustrated in Fig. 13, the electrode 31 and the electrode 32 are a comb electrode formed on the top surface of the piezoelectric film 11. On the other hand, although not illustrated, the electrode 31 and the electrode 32 as an interdigitated electrode may be formed on the bottom surface of the piezoelectric film 11. That is, the electrode 31 and the electrode 32 can be a comb electrode formed on the bottom surface of the piezoelectric film 11.

Preferably, the polarization direction in the piezoelectric film 11 and the direction of the interdigitated electrode are characterized by being parallel to each other. That is, preferably, the polarization direction in the piezoelectric film 11 is the direction of comb teeth of the electrode 31 and the electrode 32 as a comb electrode.

Here, the electrode 31 as an interdigitated electrode, that is, as a comb electrode includes: a main body 31a extending in a direction DR1 in a plan view; and a plurality of comb teeth 31b each protruding from the main body 31a in a direction DR2 that intersects, preferably orthogonal to the direction DR1 in a plan view, each extending in the direction DR2 in a plan view, and arranged in the direction DR1. Furthermore, the electrode 32 as an interdigitated electrode, that is, as a comb electrode includes: a main body 32a extending in the direction DR1 in a plan view; and a plurality of comb teeth 32b each protruding from the main body 32a in the direction DR2 that intersects, preferably orthogonal to the direction DR1 in a plan view, each extending in the direction DR2 in a plan view, and arranged in the direction DR1. The comb teeth 31b and the comb teeth 32b are alternately disposed along the direction DR1. In such a case, the direction of the interdigitated electrode is the direction DR2 in which the comb teeth 31b and the comb teeth 32b extend, and the polarization direction DP1 in the piezoelectric film 11 is the same direction as the direction DR2 in which the comb teeth 31b and the comb teeth 32b extend.

The polarization direction in the piezoelectric film 11 and the direction of the interdigitated electrode are parallel to each other, whereby an excitation of an SH wave having a higher electromechanical coupling coefficient than that of an SV wave is enabled, so that the characteristics of the SAW filter can be improved.

Note that, as described above, also with regard to the membrane structure 10 provided in the electronic device 30 of the third embodiment, there can be included the piezoelectric film 11 and the substrate 12, as with the case of the membrane structure 10 of the first embodiment. Therefore, also with regard to the membrane structure 10 provided in the electronic device 30 of the third embodiment, as with the case of the membrane structure 10 of the first embodiment, the substrate 12 can have a structure in which a Si layer and a ZrO₂ layer are layered in this order; in place of a Si substrate, an SOI substrate as a semiconductor substrate can be used for the Si layer 12a (see Fig. 4) of the substrate 12; and the electrode 13 can include the Mo layer 13c (see Fig. 3) or the W layer 13d (see Fig. 3) in place of the Pt layer 13a (see Fig. 3). Note that, a Ru layer or a Cu layer may be used besides the materials described above as the material for the electrode 13a, 13c, or 13d. Also with regard to the membrane structure 10 provided in the electronic device 30 of the third embodiment, as with the case of the membrane structure 10 of the first embodiment, the material of the piezoelectric film 11 is preferably a nitride, the material for the piezoelectric film 11 is preferably a-axis oriented AlN-based piezoelectric material, that is, the nitride is preferably AlN, the nitride is preferably doped with Sc, the polarizability of the piezoelectric film 11 is preferably 80% or more, and the film thickness of the piezoelectric film 11 is preferably 100 nm or more.

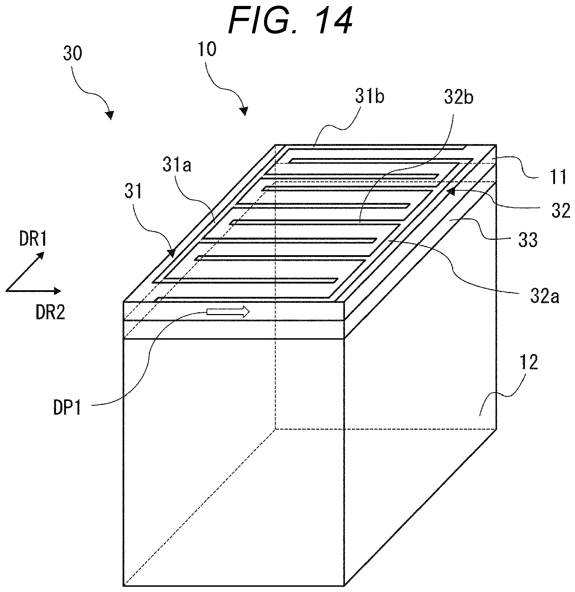

As illustrated in Fig. 14, a dielectric layer 33 as a dielectric layer or as a matching layer is preferably provided between the substrate 12 and the piezoelectric film 11. That is, the electronic device 30 illustrated in Fig. 14 includes the dielectric layer 33 as a matching layer on the substrate 12 and under the piezoelectric film 11, in addition to the portions included in the electronic device 30 illustrated in Fig. 13. As a result, there can be achieved an acoustic matching between the substrate 12 and the piezoelectric film 11. Furthermore, for example, in a case where a portion other than the dielectric layer 33 out of the electronic device 30 is made of a material having a property of softening up with an increase in temperature, and the dielectric layer 33 is made of a material having a property of stiffening up with an increase in temperature, the temperature dependence of the permittivity characteristics or of the piezoelectric characteristics, that is, the temperature characteristics of the electronic device 30 can be stabilized or adjusted.

Preferably, the dielectric layer 33 is a Si compound, for example, SiO₂. In such a case, the dielectric layer 33 is a dielectric layer made of a material having high compatibility with the manufacturing process of the semiconductor device, and hence the dielectric layer 33 can be easily formed.

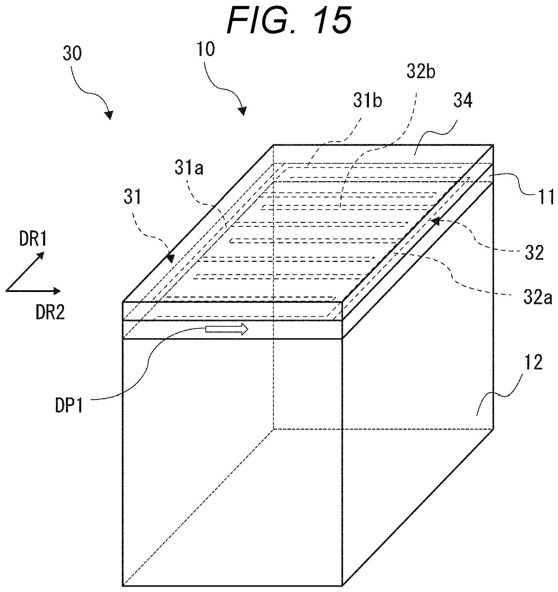

As illustrated in Fig. 15, a dielectric layer 34 is preferably provided on the piezoelectric film 11. That is, the electronic device 30 illustrated in Fig. 15 includes the dielectric layer 34 as a matching layer on the piezoelectric film 11, in addition to the portions included in the electronic device 30 illustrated in Fig. 13. As a result, there can be achieved an acoustic matching between the substrate 12 and the piezoelectric film 11. Furthermore, for example, in a case where a portion other than the dielectric layer 34 out of the electronic device 30 is made of a material having a property of softening up with an increase in temperature, and the dielectric layer 34 is made of a material having a property of stiffening up with an increase in temperature, the temperature dependence of the permittivity characteristics or of the piezoelectric characteristics, that is, the temperature characteristics of the electronic device 30 can be stabilized or adjusted.

Preferably, the dielectric layer 34 is a Si compound, for example, SiO₂. In such a case, the dielectric layer 34 is a dielectric layer made of a material having high compatibility with the manufacturing process of the semiconductor device, and hence the dielectric layer 34 can be easily formed.

### Examples

Hereinafter, the present embodiments will be described in more detail based on Examples. Note that the present invention is not limited by the following Examples.

### (Examples 1 and 2)

Hereinafter, the membrane structure 10 described in the first embodiment with reference to Figs. 2 and 3 was formed as a membrane structure of Example 1, and a test of fabricating an AlN film on a substrate containing a-axis oriented SRO (100) was carried out. In addition, a membrane structure excluding the Pt layer 13a and the SRO layer 13b from the membrane structure described with reference to Fig. 3 in the first embodiment was formed as a membrane structure of Example 2.

### [Formation of substrate]

A method of forming a substrate out of the membrane structure of Example 1 will be described. First, as a Si layer 12a (see Fig. 3), there was prepared a wafer having a top surface formed of (100) plane and made of a 6-inch silicon single crystal.

Next, a ZrO₂ layer 12b (see Fig. 3) was formed on the wafer as the Si layer 12a (see Fig. 3) by an electron beam deposition method. The conditions at this time are shown below.
Apparatus: Electron beam deposition apparatus
Pressure: 7.00 × 10⁻⁵ Pa
Evaporation source: Zr + O₂
Acceleration voltage/emission current: 7.5 kV/1.80 mA
Thickness: 60 nm
Substrate temperature: 500°C

Next, a Pt layer 13a (see Fig. 3) was formed on the ZrO₂ layer 12b (see Fig. 3) by a sputter deposition method. The conditions at this time are shown below.
Apparatus: DC sputtering apparatus
Pressure: 1.20 × 10⁻¹ Pa
Evaporation source: Pt
Power: 100 W
Thickness: 150 nm
Substrate temperature: 450 to 600°C

Next, an SRO layer 13b (see Fig. 3) was formed on the Pt layer 13a (see Fig. 3) by a sputter deposition method. The conditions at this time are shown below.
Apparatus: RF magnetron sputtering apparatus
Power: 300 W
Gas: Ar
Pressure: 1.8 Pa
Substrate temperature: 600°C
Thickness: 40 nm

On the other hand, a wafer where neither Pt layer 13a (see Fig. 3) nor SRO layer 13b (see Fig. 3) was formed on the ZrO₂ layer 12b (see Fig. 3) was used as a substrate of the membrane structure of Example 2.

### [Θ-2Θ spectrum of substrate]

For Example 1, the Θ-2Θ spectrum in XRD method for the membrane structure formed up to the SRO layer 13b (see Fig. 3) was measured. That is, an X-ray diffraction measurement by the Θ-2Θ method was carried out for the membrane structure of Example 1 formed up to the SRO layer 13b. Note that, the XRD data for the present Example is obtained by using an X-ray diffractometer SmartLab manufactured by Rigaku Corporation.

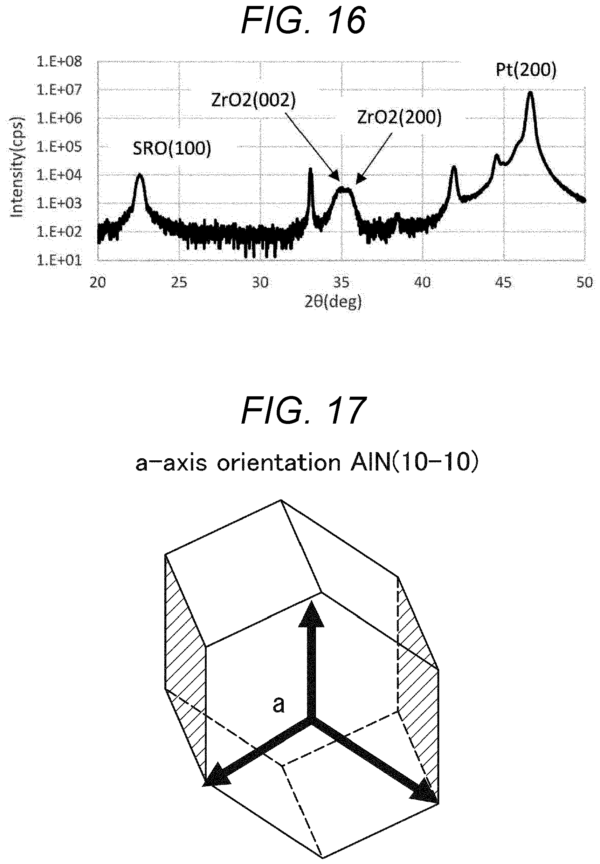

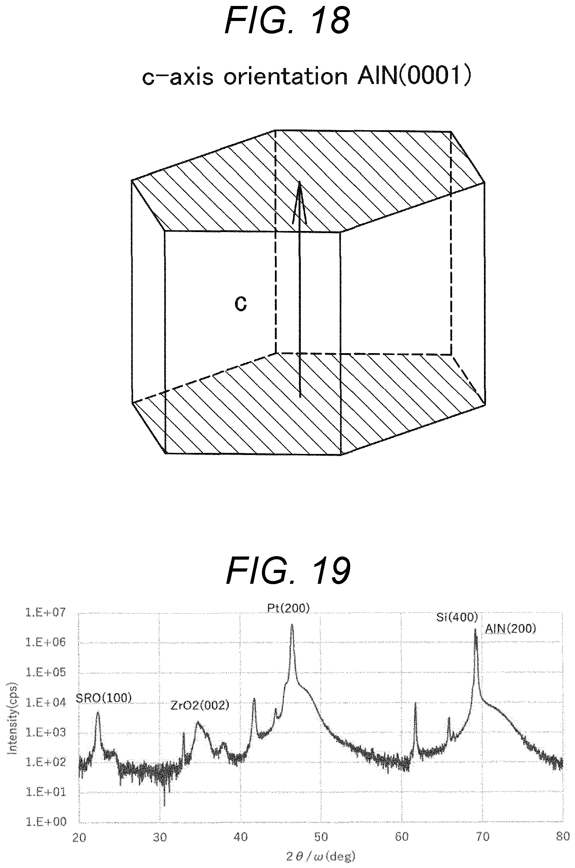

Fig. 16 is a graph showing an example of Θ-2Θ spectrum by the XRD method for the membrane structure of Example 1 formed up to the SRO layer. The horizontal axis of the graph in Fig. 16 indicates angle 2θ, and the vertical axis of the graph in Fig. 16 indicates X-ray intensity (the same applies to Figs. 19, 20, and 22 described later). Fig. 16 shows a range of 20° ≤ 2θ ≤ 50°.

In the example (Example 1) shown in Fig. 16, peaks corresponding to the (002) plane and the (200) plane of ZrO₂, the (200) plane of Pt, and the (100) plane of SRO were observed in the Θ-2Θ spectrum.

### [Formation of piezoelectric film]

In Example 1, next, a piezoelectric film 11 (see Fig. 3) made of AlN was formed on the SRO layer 13b (see Fig. 3) by a sputter deposition method. The conditions at this time are shown below.
Apparatus: DC sputtering apparatus
Pressure: 2 Pa
Evaporation source (target): Al
Gas: Ar/N₂
Power: 450 W
Substrate temperature: 450°C
Thickness: 600 nm

On the other hand, in Example 2, a piezoelectric film 11 made of AlN was formed directly on the ZrO₂ layer 12b (see Fig. 3) by a sputter deposition method. The other conditions were the same as in Example 1.

### [Out-of-plane measurement]

For Example 1, an evaluation of the crystallinity for a sample of a membrane structure formed up to the piezoelectric film 11 (see Fig. 3), that is, for a sample having AlN deposited on the membrane structure formed up to the SRO layer 13b (see Fig. 3) was carried out with an X-ray diffractometer (XRD) (out-of-plane measurement and reciprocal-space map measurement). Note that, also for Example 2, an evaluation of the crystallinity was carried out by the out-of-plane measurement.

First of the out-of-plane measurement and the reciprocal-space map measurement, the out-of-plane measurement was carried out. The out-of-plane measurement causes an X-ray beam to be incident from the surface, that is, to be incident approximately parallel to the surface thereby grasping the crystal structure. Herewith, the direction of AlN orientation is confirmed. For reference, the definitions for a-axis-oriented plane and c-axis-orientated plane are shown in Figs. 17 and 18. Fig. 17 is a diagram illustrating a crystal structure of a-axis-oriented AlN, and Fig. 18 is a diagram illustrating a crystal structure of c-axis-oriented AlN. As described above, AlN has a hexagonal wurtzite structure and is polarized in c-axis direction. In Fig. 17, the hatched area represents a-plane, and a-axis represents a1(100) axis. In Fig. 18, the hatched area represents c-plane, and c-axis represents c(001) axis.

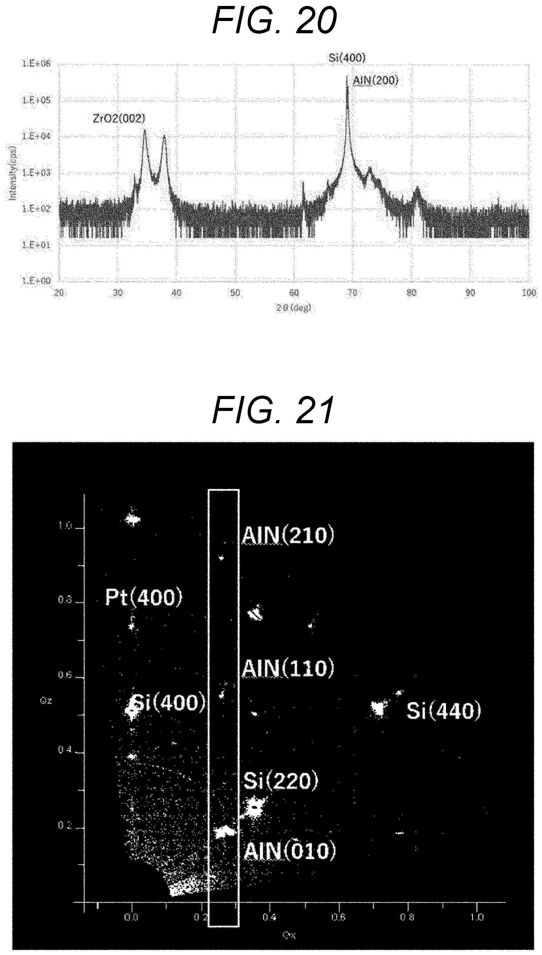

Fig. 19 is a graph showing the results of the out-of-plane measurement for the membrane structure of Example 1. Fig. 20 is a graph showing the results of the out-of-plane measurement for the membrane structure of Example 2. Fig. 19 shows the range of 20° ≤ 2θ ≤ 80°, and Fig. 20 shows the range of 20° ≤ 2θ ≤ 100°.

As shown in Fig. 19, for the membrane structure of Example 1, an AlN(200) peak was confirmed in the vicinity of 2θ = 69.5°. An AlN (100) peak to be shown in the vicinity of 2θ = 33.1° was not confirmed. The AlN (100) peak is considered to be hidden behind the tail of ZrO₂ (002) peak due to its low intensity.

On the other hand, as shown in Fig. 20, in the case of the membrane structure of Example 2, that is, in the case where AlN was deposited directly on ZrO₂, the peak intensity was lower by one order of magnitude than that in the case where AlN was deposited on SRO, but an AlN(200) peak was confirmed in the vicinity of 2θ = 69.5°. From this, it can be said that AlN is a-axis oriented even deposited directly on ZrO₂.

### [Reciprocal-space map measurement]

Next, a reciprocal-space map measurement was carried out for Example 1. The reciprocal-space map measurement is a three-dimensional observation for a film to be measured to identify the fluctuation of a lattice constant and the inclination of a lattice plane.

Fig. 21 is a graph showing the results of the reciprocal-space map measurement for the membrane structure of Example 1. As shown in Fig. 21, the peaks for the a-axis direction of AlN(010) were confirmed to be in line in the vertical direction, and hence the planes were aligned. In addition, the crystal vertices are clear and it can be said that the fluctuation in crystal is little. Note that AlN(010) is a-axis oriented same as with AlN(100).

From the above results, it was found that AlN deposited on the membrane structure of Example 1 is a-axis oriented. It was also found that there was no fluctuation in AlN crystal, and the lattice planes were aligned. From the above, it was found that AlN deposited on SRO/Pt/ZrO₂/Si, preferably AlN deposited on SRO(100)/Pt(100)/ZrO₂(200) and ZrO₂(002) was a-axis orientated and single crystallized. Also with regard to Example 2, similar results were obtained.

In general, AlN (aluminum nitride) is considered to be c-axis oriented. In Example 1, a test of preparing an AlN film on a substrate containing a-axis oriented SRO (100) was carried out. As a result, it has been found that an a-axis oriented AlN film was obtained, and that there was no fluctuation in the crystal and the lattice planes were aligned. From these, it has been found that when AlN is deposited on Pt/ZrO₂/Si in the membrane structure described above, the layer is epitaxially grown, and AlN is single crystallized with a-axis orientation.

### (Example 3)

Next, the membrane structure 10 described in the first embodiment with reference to Figs. 2 and 3 was formed as a membrane structure of Example 3, and a test of measuring the electrical characteristics thereof was carried out.

### [Formation of substrate]

For the membrane structure of Example 3, a substrate was formed by the same method as with the membrane structure of Example 1.

### [Formation of piezoelectric film]

For the membrane structure of Example 3, a piezoelectric film was formed in the same manner as with the membrane structure of Example 1. However, the pressure used was 0.26 Pa, and the power used was 500 W.

### [Θ-2Θ Spectrum of membrane structure]

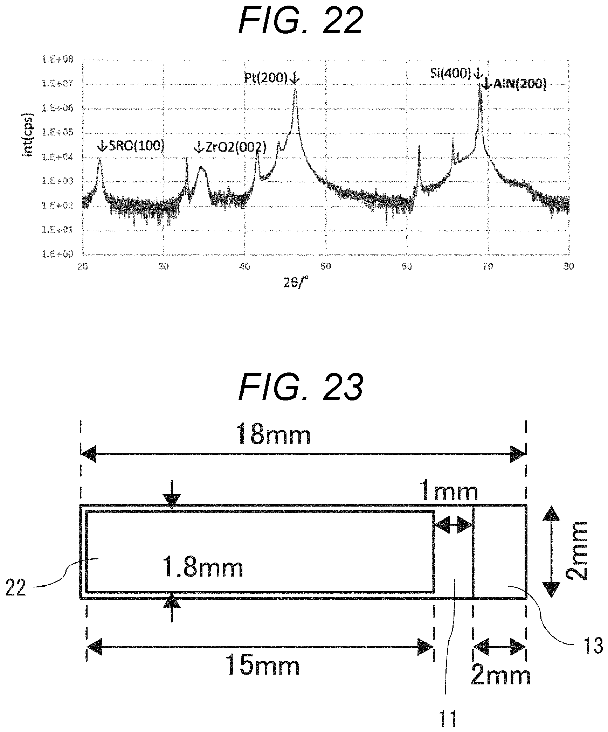

An X-ray diffraction measurement by the Θ-2Θ method was carried out for the membrane structure of Example 3. Fig. 22 is a graph showing an example of Θ-2Θ spectrum by XRD method for the membrane structure of Example 3. Fig. 22 shows the range of 20° ≤ 2θ ≤ 80°.

As shown in Fig. 22, it has been able to be confirmed that the AlN film deposited on the SRO(100) substrate, namely, the AlN film deposited on the SRO(100)/Pt(100)/ZrO₂(200) and ZrO₂(002) had AlN(200) peak, and AlN is found to be a-axis oriented.

### [Amount of displacement]

For the membrane structure of Example 3, a sample having a cantilever shape and a sample having a pad shape were prepared, and a top electrode (Pt: 100 nm) was deposited on the AlN film thereby measuring the electrical characteristics of the membrane structure of Example 3. The structure is illustrated in Figs. 23 to 26.

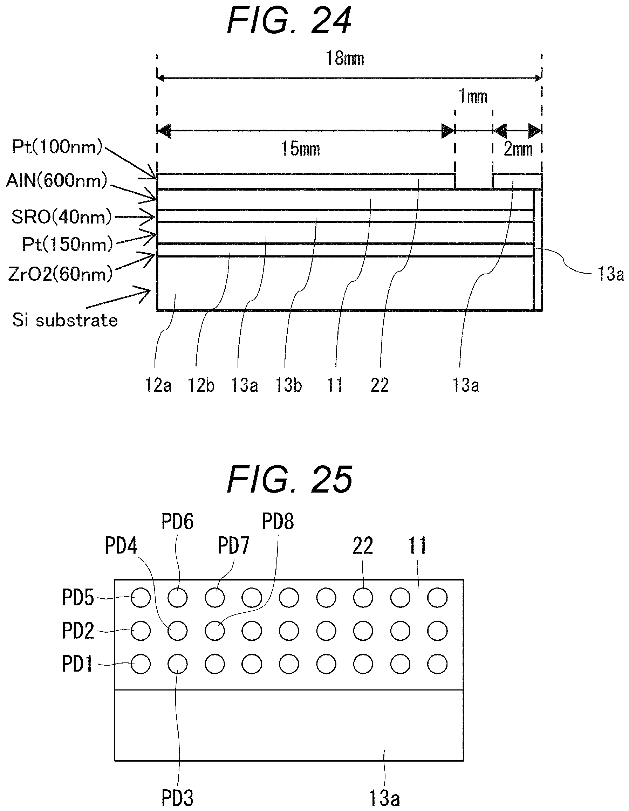

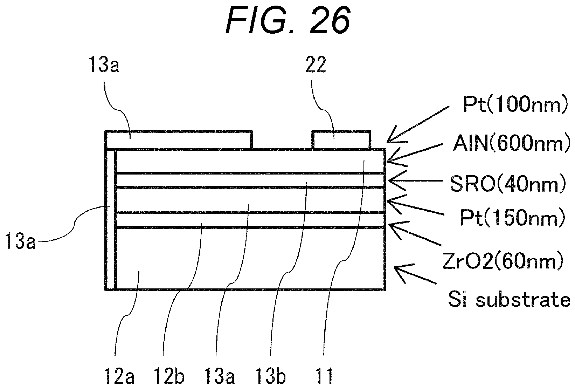

Fig. 23 is a plan view of the sample having a cantilever shape of the membrane structure of Example 3. Fig. 24 is a cross-sectional view of the sample having a cantilever shape of the membrane structure of Example 3. Fig. 25 is a plan view of the sample having a pad shape of the membrane structure of Example 3. Fig. 26 is a cross-sectional view of the sample having a pad shape of the membrane structure of Example 3.

As illustrated in Figs. 24 and 26, the sample having a cantilever shape and the sample having a pad shape each are a stack in which ZrO₂ (60 nm) as a ZrO₂ layer 12b, Pt (150 nm) as a Pt layer 13a, SRO (40 nm) as an SRO layer 13b, AlN (600 nm) as a piezoelectric film 11, and Pt (100 nm) as an electrode 22 are sequentially layered on a Si substrate as a Si layer 12a. The numerical value in the parenthesis for each layer in Figs. 24 and 26 indicates the film thickness thereof. In addition, as illustrated in Figs. 24 and 26, the sample has a structure in which Pt as the Pt layer 13a is formed on the side surface thereby allowing an electrical connection between the top and bottom Pt electrodes, and in which the Pt layer 13a as a bottom electrode is extended to the top surface of the piezoelectric film 11. Note that, when eight pads are denoted by pads PD1 to PD8, the pads PD1 to PD8 each have a diameter of 1 mm.

With the sample having a cantilever shape illustrated in Figs. 23 and 24, the amount of displacement at the time when a voltage was applied between the top electrode and the bottom electrode was measured. The measurement conditions and the dimensions of the sample at this time were as follows.
Applied voltage: 20 Vₚₚ; offset = -10 V; Fᵣ = 700 Hz; Sine wave
Sample: 20 × 2 × 0.725 mm

The measurement results of the amount of displacement at the time when the voltage between the top electrode and the bottom electrode was set to 35 V are shown in Table 1.

**[Table 1]**

| Item | Displacement [µm] @ 35 V (Literature data approx. 0.51 µm @ 35V) |
|---|---|
| Amount of displacement (Measurement with cantilever sample) | First measurement: 0.16 |
| | Second measurement: 0.14 |

As shown in Table 1, in the first measurement, an amount of displacement of 0.16 um was obtained at 35 V, and in the second measurement an amount of displacement of 0.14 um was obtained at 35 V. These amounts of displacement are about 1/3 times smaller than approximately 0.51 um as the value for the amount of displacement at 35 V reported as the literature data in Non-Patent Literature 1 and the like, for example, however, it is decided that there is no problem in view of the fact that a larger amount of displacement is enabled to be achieved in the future by adjusting the deposition conditions, and that the amount of displacement is not a parameter that is required so much in a case where AlN is used in filter applications, that is, AlN per se has a small amount of displacement by nature.

### [Permittivity]

With the cantilever sample shown in Fig. 23 and the pad samples PD7 and PD8 shown in Fig. 25, the permittivities thereof were measured at the time when a voltage was applied between the top electrode and the bottom electrode. The measurement conditions at this time were as follows.
Measurement conditions: Cₚ-Rₚ; Fᵣ = 1 kHz; Vₚₚ = 1 V

The results are shown in Table 2.

**[Table 2]**

| Sample used | Relative permittivity (Literature data approx. 9) |
|---|---|
| Pad PD7 | 3.85 |
| Pad PD8 | 3.93 |
| Cantilever | First measurement 3.76 |
| | Second measurement 3.83 |

As shown in Table 2, the relative permittivity is less than or equal to the half of the literature data of approximately 9 as a reported value in Non-Patent Literature 1 or the like, for example, and it can be said that a film having good characteristics has been formed.

### [Withstand voltage]

With the pads PD1 to PD6 illustrated in Fig. 25, the withstand voltages thereof were measured at that time when a voltage was applied between the top electrode and the bottom electrode. The measurement conditions at this time were as follows. Note that the withstand voltages of this example were measured with SourceMeter Model 2450 manufactured by Keithley Instruments LLC.

The condition: voltage 0 V → -200 V; step: 5 V/step or 4 V/step

Taking each film thickness into consideration, the voltage at each step was set so as to be marked at an equal interval with electric field intensity.
Retention time: 5 sec
Limit current: 105 µA

In addition, as the definition of breakdown, the measurement was stopped at the timing when the PZT film undergoes dielectric breakdown, but it was decided that the breakdown occurs when a current through it was or exceeded the limit current set to 105 µA. In addition, the voltage at one step prior to the breakdown voltage was defined as the withstand voltage.

The results are shown in Table 3.

**[Table 3]**

| Item | Withstand voltage [-V/µm] Literature data approx. 60 V/µm) |
|---|---|
| Pad PD1 | 357.5 |
| Pad PD2 | (397.5) Maximum value of device |
| Pad PD3 | (397.5) Maximum value of device |
| Pad PD4 | (397.5) Maximum value of device |
| Pad PD5 | (397.5) Maximum value of device |
| Pad PD6 | (397.5) Maximum value of device |

As shown in Table 3, the withstand voltages were higher than the maximum voltage of the device at five out of six places. In addition, it has been confirmed that the withstand voltage is 5 times or more better than the literature data of approximately 60 V/pm reported in Non-Patent Literature 1 and the like, for example. Therefore, it can be said that AlN deposited on the SRO(100) substrate, namely, AlN deposited on SRO(100)/Pt(100)/ZrO₂(200) and ZrO₂(002) is excellent in withstand voltage characteristics.

To summarize the above results, the following results were obtained as the characteristics of AlN (with a-axis orientation) deposited on the SRO(100) substrate. Note that Vₚ₋ₚ represents the amplitude from the maximum to the minimum of the voltage waveform.
Amount of displacement: 0.14 to 0.16 um corresponding @ 35 Vₚ₋ₚ (literature data: 0.51 um)
Relative permittivity: < 3.93 (literature data: ca. 9)
Withstand voltage: 350 V/pm or more (literature data: 60 V/µm)

As shown as the membrane structure of Example 1, it has been able to be confirmed that when an AlN film is formed on the substrate containing a-axis oriented SRO(100), it becomes an a-axis oriented single crystal. For Example 3, tests were carried out on the electrical characteristics (amount of displacement, permittivity, and withstand voltage) of the a-axis oriented AlN single-crystal. As a result, the amount of displacement was less than the value reported as the literature data in Non-Patent Literature 1 and the like, but the permittivity and the withstand voltage exhibited characteristics better than the value reported as the literature data in Non-Patent Literature 1 and the like.

The invention made by the present inventors has been specifically described above based on the embodiments thereof, however, the present invention is not limited to the embodiments described above, and it will be obvious that various changes can be made without departing from the gist of the invention.

Within the scope of the idea of the present invention, those skilled in the art would conceive various changes and modifications, and it is understood that their change examples and modification examples also fall within the scope of the present invention.

For example, examples those skilled in the art appropriately made by addition, deletion, or a design change of a constituent element, or made by addition, omission, or a condition change of a step for the embodiment described above are also included in the scope of the present invention as long as the gist of the present invention is included therein.

Parts of the contents set forth in the aforementioned embodiments will be described below.

### [Appendix 1]

A membrane structure including,
a piezoelectric film made as a membrane on Pt/ZrO₂/Si,
a polarization direction in the piezoelectric film being preferentially oriented parallel to a substrate.

### [Appendix 2]

The membrane structure according to Appendix 1, wherein the piezoelectric film is made of a nitride.

### [Appendix 3]

The membrane structure according to Appendix 2, wherein the nitride is AlN.

### [Appendix 4]

A membrane structure including,
a piezoelectric film made as a membrane on Pt/ZrO₂/Si on SOI,
a polarization direction in the piezoelectric film being preferentially oriented parallel to a substrate.

### [Appendix 5]

The membrane structure according to Appendix 4, wherein the piezoelectric film is made of a nitride.

### [Appendix 6]

The membrane structure according to Appendix 5, wherein the nitride is AlN.

### [Appendix 7]

The membrane structure according to any of Appendices 1 to 6, wherein a polarizability is 80% or more.

### [Appendix 8]

The membrane structure according to Appendix 3 or 6, wherein a film thickness of AlN is 100 nm or more.

### [Appendix 9]

The membrane structure according to any of Appendices 1 to 8, including a second electrode formed on the piezoelectric film.

### [Appendix 10]

The membrane structure according to Appendix 2 or 5, including the piezoelectric film in which Sc is doped in the nitride.

### [Appendix 11]

The membrane structure according to any of Appendices 1 to 10, having a structure in which SRO is included on Pt underlayer.

### [Appendix 12]

The membrane structure according to Appendix 3 or 6, including AlN on an underlayer film with use of Mo or W instead of Pt.

### [Appendix 13]

The membrane structure according to any of Appendices 1 to 12, wherein the piezoelectric film is of a single crystal.

### [Appendix 14]

An electronic device including,
an electrode and a piezoelectric film,
a polarization direction in the piezoelectric film being preferentially oriented parallel to a substrate.

### [Appendix 15]

The electronic device according to Appendix 14, wherein a comb electrode is formed on a top surface or a bottom surface of the piezoelectric film.

### [Appendix 16]

The electronic device according to Appendix 14 or 15, wherein the piezoelectric film is made of a nitride.

### [Appendix 17]

The electronic device according to any of Appendices 14 to 16, wherein the nitride is AlN.

### [Appendix 18]

The electronic device according to any of Appendices 14 to 17, wherein a polarizability is 80% or more.

### [Appendix 19]

An electronic device including,
an electrode, a piezoelectric film, and a matching layer,
a polarization direction in the piezoelectric film being preferentially oriented parallel to a substrate.

### [Appendix 20]

The electronic device according to Appendix 19, wherein the matching layer is a Si compound.

### [Appendix 21]

The electronic device according to any of Appendices 14 to 20, wherein a polarization direction in the piezoelectric film is a direction of comb teeth of a comb electrode.

### [Appendix 22]

An electronic device including,
an electrode and a piezoelectric film,
a polarization direction in the piezoelectric film being preferentially oriented parallel to a substrate, and
a hollow part being provided below the piezoelectric film.

### [Appendix 23]

An electronic device including,
an electrode and a piezoelectric film,
a polarization direction in the piezoelectric film being preferentially oriented parallel to a substrate,
electrodes being formed on top and bottom of the piezoelectric film, and
a hollow part being provided below the piezoelectric film.

### [Appendix 24]

An electronic device including,
an electrode and a piezoelectric film,
a polarization direction in the piezoelectric film being preferentially oriented parallel to a substrate,
electrodes being formed above and below in contact with the piezoelectric film, and
a hollow part being provided below the piezoelectric film.

### [Appendix 25]

An electronic device including,
an electrode and a piezoelectric film,
a polarization direction in the piezoelectric film being preferentially oriented parallel to a substrate,
electrodes being formed on top and bottom of the piezoelectric film,
a hollow part being provided below the piezoelectric film, and
an overlapping area between the top and bottom electrodes being smaller than an area of the hollow part.

### [Appendix 26]

The electronic device according to any of Appendices 23 to 25, wherein an area of an overlapping portion between top and bottom electrodes is 1/2 or less of an area of the hollow part.

### [Appendix 27]

The electronic device according to any of Appendices 22 to 26, wherein the piezoelectric film is made of a nitride.

### [Appendix 28]

The electronic device according to Appendix 27, wherein the nitride is AlN.

### [Appendix 29]

The electronic device according to any of Appendices 22 to 28, wherein a polarizability is 80% or more.

### [Appendix 30]

The electronic device according to any of Appendices 23 to 26, wherein a matching layer is provided under a bottom electrode.

### [Appendix 31]

The electronic device according to Appendix 30, wherein the matching layer is a Si compound.

### [Appendix 32]

The electronic device according to Appendix 28, wherein a film thickness of AlN is 100 nm or more.

### [Appendix 33]

An electric device including,
an electrode and a piezoelectric film,
a polarization direction in the piezoelectric film being preferentially oriented parallel to a substrate, and
either top or bottom of the piezoelectric film being not fixed.

### [Appendix 34]

The electronic device according to Appendix 33, wherein the piezoelectric film is made of a nitride.

### [Appendix 35]

The electronic device according to Appendix 34, wherein the nitride is AlN.

### [Appendix 36]

The electronic device according to any of Appendices 33 to 35, wherein a polarizability is 80% or more.

### [Appendix 37]

An electronic device including,
an electrode and a piezoelectric film,
a polarization direction in the piezoelectric film being preferentially oriented parallel to a substrate,
one side of the piezoelectric film being fixed, and
the other side of the piezoelectric film being fixed weakly with a material whose hardness varies with temperature.

### [Appendix 38]

An electronic device including,
an electrode and a piezoelectric film,
a polarization direction in the piezoelectric film being preferentially oriented parallel to a substrate,
electrodes being provided on top and bottom of the piezoelectric film, and
either top or bottom electrode including a plurality of the electrodes, so that two or more kinds of electric field directions are included in a plane.

### [Appendix 39]

An electronic device including,
an electrode and a piezoelectric film,
a polarization direction in the piezoelectric film being parallel to a substrate and preferentially oriented in a plurality of directions, and
electrodes being provided on top and bottom of the piezoelectric film.

### [Appendix 40]

An electronic device including,
an electrode and a piezoelectric film,
a polarization direction in the piezoelectric film being preferentially oriented parallel to a substrate, and
a plurality of electrodes being provided on top and bottom of the piezoelectric film.

### Reference Signs List

- 10: Membrane structure
- 11: Piezoelectric film
- 12: Substrate
- 12a: Si layer
- 12b: ZrO₂ layer
- 12c: Substratum
- 12d: BOX layer
- 13: Electrode
- 13a: Pt layer
- 13b: SRO layer
- 13c: Mo layer
- 13d: W layer
- 20, 30: Electronic device
- 21: Hollow part
- 22, 22a, 22b, 31, 32: Electrode
- 23, 24, 33, 34: Dielectric layer
- 31a, 32a: Main body
- 31b, 32b: Comb teeth
- DP1: Polarization direction
- DR1, DR2: Direction
- PD1 to PD8: Pad

## Claims

1. A membrane structure comprising:
a substrate being a Si substrate or an SOI substrate;
a buffer film containing ZrO₂ and formed on the substrate; and
a piezoelectric film formed on the buffer film,
a polarization direction in the piezoelectric film being preferentially oriented parallel to the substrate.

2. The membrane structure according to claim 1, wherein a metal film is further provided on the buffer film.

3. The membrane structure according to claim 2, wherein the metal film is a Pt film, a Mo film, a W film, a Ru film, or a Cu film.

4. The membrane structure according to claim 2 or 3, wherein an SRO film is further provided on the metal film.

5. The membrane structure according to any of claims 1 to 4, wherein the piezoelectric film is made of a nitride.

6. The membrane structure according to claim 5, wherein the nitride is AlN.

7. The membrane structure according to claim 5 or 6, wherein the nitride is doped with Sc.

8. An electronic device fabricated from the membrane structure according to any of claims 1 to 7.

9. An electronic device fabricated from the membrane structure according to claim 1, a comb electrode being provided on a top surface or a bottom surface of the piezoelectric film in the membrane structure.

10. The electronic device according to claim 9, wherein a polarization direction in the piezoelectric film is a direction of comb teeth of the comb electrode.

11. The electronic device according to claim 9 or 10, wherein a matching layer is included on the substrate.

12. The electronic device according to claim 8, wherein a hollow part is provided below the piezoelectric film.

13. The electronic device according to claim 12, wherein a top electrode and a bottom electrode are provided on top and bottom of the piezoelectric film.

14. The electronic device according to claim 13, wherein an area of an overlapping portion between the top electrode and the bottom electrode is smaller than an area of the hollow part.

15. The electronic device according to claim 13, wherein an area of an overlapping portion between the top electrode and the bottom electrode is 1/2 or less of an area of the hollow part.

16. The electronic device according to any of claims 12 to 15, wherein a matching layer is included on the substrate.

17. The electronic device according to claim 11 or 16, wherein the matching layer is made of a material whose hardness increases with an increase in temperature.

18. The electronic device according to claim 17, wherein the material is a Si compound.

19. The electronic device according to claim 8, wherein either top or bottom of the piezoelectric film is fixed.

20. The electronic device according to any of claims 8 to 19, wherein the piezoelectric film is made of a nitride.
